(19) Europäisches Patentamt
European Patent Office
Office européen des brevets

(11) Veröffentlichungsnummer: **0 252 883**
**B1**

(12) **EUROPÄISCHE PATENTSCHRIFT**

(45) Veröffentlichungstag der Patentschrift: **16.01.91**

(51) Int. Cl.$^5$: **G 03 F 7/038,** C 08 G 73/10

(21) Anmeldenummer: **87810383.7**

(22) Anmeldetag: **02.07.87**

# (54) Beschichtetes Material enthaltend eine strahlungsempfindliche Polyimidschicht mit speziellen Diaminodiphenylmethaneinheiten.

(30) Priorität: **08.07.86 CH 2753/86**

(43) Veröffentlichungstag der Anmeldung:
**13.01.88 Patentblatt 88/02**

(45) Bekanntmachung des Hinweises auf die Patenterteilung:
**16.01.91 Patentblatt 91/03**

(84) Benannte Vertragsstaaten:
**CH DE FR GB IT LI NL**

(56) Entgegenhaltungen:
EP-A-0 132 221
EP-A-0 134 752
EP-A-0 141 781
EP-A-0 162 017
EP-A-0 181 837
EP-A-0 182 745
EP-A-0 203 393
EP-A-0 214 103
DE-A-3 007 445
FR-A-1 565 700

**Die Akte enthält technische Angaben, die nach dem Eingang der Anmeldung eingereicht wurden und die nicht in dieser Patentschrift enthalten sind.**

(73) Patentinhaber: **CIBA-GEIGY AG**
**Klybeckstrasse 141**
**CH-4002 Basel (CH)**

(72) Erfinder: **Pfeifer, Josef, Dr.**
**Brunnmattstrasse 32**
**CH-4106 Therwil (CH)**
Erfinder: **Duthaler, Rudolf, Dr.**
**Girenhaldenweg 17**
**CH-4126 Bettingen (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 252 883 B1

**Beschreibung**

Die vorliegende Erfindung betrifft ein mit speziellen strahlungsvernetzbaren Polyimiden beschichtetes Material, ein Verfahren zur Herstellung von Schutzüberzügen, Filmen und Reliefabbildungen, die durch diese Verfahren erhältlichen vernetzten Produkte sowie die Verwendung des beschichteten Materials zur Herstellung von Isolier-, Passier- und Schutzschichten und von Reliefabbildungen.

Strahlungsvernetzbare Polyimide sind bekannt. In der EP—A 134,752 werden direkt vernetzbare Beschichtungen beschrieben, bei denen ein Polymeres mit mindestens 5 Mol-% Benzophenontetracarbonsäureimideinheiten verwendet wird. Ferner sind aus den EP—A 132,221 und 162,017 lösliche und gleichzeitig autophotovernetzbare Polyimide bekannt, die sich von aromatischen Diaminen ableiten, welche in beiden Orthostellungen zu mindestens einer Aminogruppe substituiert sind. Die Polymeren besitzen einen Mindestanteil an Benzophenontetracarbonsäureeinheiten oder an Einheiten anderer aromatischer Tetracarbonsäuren, bei denen die carboxylgruppenhaltigen aromatischen Reste über Carbonylgruppen an weitere aromatische Reste gebunden sind.

Weiter beschreibt die EP—A 141 781 als strahlungsempfindliches Beschichtungsmaterial in organischen Lösungsmitteln gelöste Polyimide mit mindestens 50 Mol% an aromatischen Tetracarbonsäureimideinheiten sowie organische chromophore Polyazide. Autophotovernetzbare Polyimide aus aromatischen Tetracarbonsäuren, deren aromatische Kerne durch aromatische oder cycloaliphatische annelierte Ringe substituiert sind, und organischen Diaminen sind aus der EP—A 181 837 bekannt. Schliesslich beschreibt die EP—A 182 745 von Aminodicarbonsäure abgeleitte Polyimide, die als weitere Strukturelement Polyimide aus aromatischen Tetracarbonsäuren und organischen Diaminen enthalten können, und die autophotovernetzbar sind.

Die vorbekannten direkt vernetzbaren Polyimide zeichnen sich bereits durch eine hohe Lichtempfindlichkeit aus. Generell besteht allerdings ein Bedarf an weiteren, noch empfindlichen Polymeren, um beispielsweise die Belichtungszeiten und somit die Durchsatzgeschwindigkeit durch Belichtungspparaturen weiter zu verringern.

Es wurde jetzt eine ausgewählte Gruppe von Polyimiden mit speziellen Diaminodiphenylmethanresten gefunden, die, verglichen mit strukturell ähnlichen Verbindungen gleichen Molekulargewichte, eine erhöhte Photoempfindlichkeit aufweisen. Ueberraschenderweise sind auch Polyimide mit unsubstituierten Diaminresten dieses Typs photovernetzbar.

Polyimide aus Benzophenontetracarbonsäure und 2,2'-Diaminodiphenylmethan werden von V. L. Bell in J. Polym. Sci. Pol. Chem. Ed., *14,* 2275—2292 (1976) beschrieben. Zur Herstellung von Polyimidfilmen wird dort u.a. eine Polyamidsäure aus Benzophenontetracarbonsäuredianhydrid und 2,2'-Diaminodiphenylmethan auf Glasplatten übertragen und anschliessend thermisch cyclisiert. Die Herstellung von Reliefstrukturen oder die Strahlungsvernetzung der Polyimidschicht wird allerdings nicht erwähnt.

Die vorliegende Erfindung betrifft ein beschichtetes Material aus mindestens einem Träger und einer darüberliegenden strahlungsempfindlichen zumindest teilweise cyclisierten Polyamidsäure- oder Polyimidschicht, dadurch gekennzeichnet, dass das Polymere mindestens 5 Mol%, bezogen auf das Gesamtpolymere, an Struktureinheiten der Formel I enthält

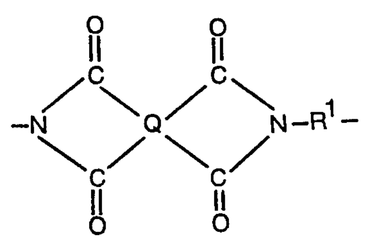

(I),

worin der Rest Q ausgewählt ist aus der Gruppe bestehend aus

a) Derivaten der Benzophenontetracarbonsäure

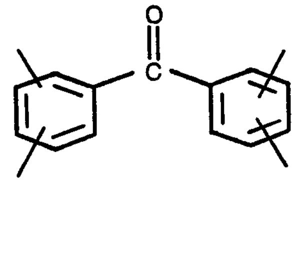

und

b) Strukturen der Formel III

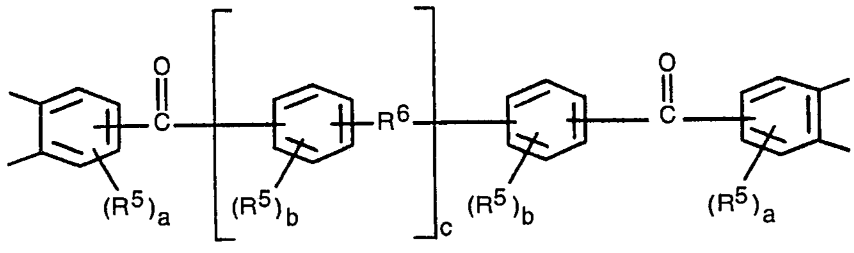

(III),

worin $R^5$ für $C_1$—$C_6$Alkyl, $C_1$—$C_6$Alkoxy, $C_1$—$C_6$Alkylthio, Phenyl, Phenyloxy oder Phenylthio steht, $R^6$ eine direkte Bindung oder eine Brückengruppe der Formeln —O—, —S—, —$SO_2$—, —$CH_2$—, —$C(CH_3)_2$— oder —CO— bedeutet a für 0, 1, 2 oder 3, b für 0, 1, 2, 3 oder 4 und c für 0, 1, 2, 3, 4 oder 5 steht, und, wenn a und b 2 sind, beide $R^5$ zusätzlich zu den obigen Definitionen in o-Stellung gebunden sind und zusammen —CH=CH—CH=CH— bedeuten, und $R^1$ ein Rest der Formel II ist

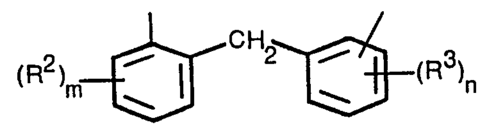

(II),

worin $R^2$ und $R^3$ unabhängig voneinander Alkyl, Cycloalkyl oder Aralkyl bedeuten oder jeweils zwei Reste $R^2$ oder $R^3$ in ortho-Position zueinander stehen und zusammen eine Tetramethylenkette bilden und m und n unabhängig voneinander ganze Zahlen von 0 bis 4 sind, jedoch nicht gleichzeitig 0 werden können wobei Glas als Trägermaterial ausgeschlossen ist.

Der Index c ist vorzugsweise 0. Die Indizes a und b sind vorzugsweise 0 oder 1.

Besonders bevorzugte Strukturelemente dieses Typs entsprechen der Formel IIIa oder IIIb

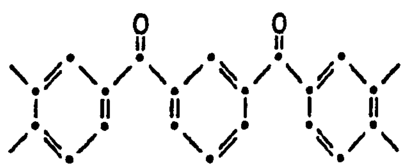

(IIIa),

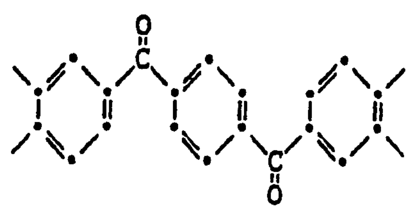

(IIIb).

Bedeuten irgendwelche Reste Alkyl, so handelt es dabei in der Regel um $C_1$—$C_{20}$Alkyl. Die Alkylreste können verzweigt oder unverzweigt sein. Bevorzugt werden unverzweigte Reste.

Beispiele für $C_1$—$C_{20}$Alkyl sind Methyl, Ethyl, n-Propyl, Isopropyl, n-Butyl, sek.Butyl, tert.Butyl, n-Pentyl, Isoamyl, n-Hexyl, n-Heptyl, n-Octyl, 2-Ethylhexyl, n-Nonyl, n-Decyl, n-Dodecyl, n-Tetradecyl, n-Hexadecyl, n-Octadecyl oder n-Eicosyl. Bevorzugt werden $C_1$—$C_6$Alkylreste, besonders Methyl, Ethyl, n-Propyl, Isopropyl, n-Butyl und n-Hexyl, insbesondere jedoch Methyl.

Bedeuten irgendwelche Reste Cycloalkyl, so handelt es sich dabei in der Regel um $C_5$—$C_7$Cycloalkyl. Beispiele für solche Reste sind Cyclopentyl, Cyclohexyl oder Cycloheptyl. Bevorzugt wird Cyclohexyl.

Handelt es sich bei irgendwelchen Resten um Aralkyl, so sind dies in der Regel $C_7$—$C_{14}$Aralkylgruppen. Beispiele dafür sind Benzyl, α-Methylbenzyl, α,α-Dimethylbenzyl oder 4-Methylbenzyl. Bevorzugt wird Benzyl.

$R^5$ als $C_1$—$C_6$Alkoxy ist beispielsweise Methoxy, Ethoxy, n-Propoxy, n-Butoxy und n-Hexoxy. Bevorzugt wird Methoxy. $R^5$ ist als $C_1$—$C_6$Alkylthio beispielsweise Methylthio, Ethylthio, n-Propylthio, n-Butylthio oder n-Hexylthio. Bevorzugt wird Methylthio.

Der Rest $R^1$ ist bevorzugt eine Gruppe der Formel IIa

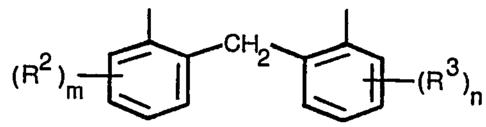

(IIa),

Von den Diaminodiphenylmethanresten der Formeln II und IIa werden insbesondere die unsubstituierten oder die alkylsubstituierten Typen bevorzugt und davon besonders diejenigen, worin 0 bis 4 $C_1$—$C_6$Alkylgruppe pro Phenylkern vorhanden sind. Als Alkylsubstituenten der Reste II und IIa werden insbesondere Methyl und/oder Ethyl bevorzugt.

Ganz besonders bevorzugt verwendet man Polymere wie oben definiert, worin $R^1$ ein Rest der Formel IIb ist

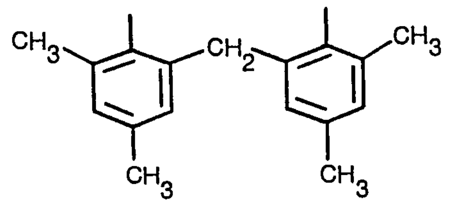

(IIb).

Ebenfalls bevorzugt werden polymere Beschichtungsmaterialien wie oben definiert eingesetzt, worin der Anteil der Struktureinheiten der Formel I 30—100 Mol-%, bevorzugt 50—100 Mol-% ausmacht.

Ganz besonders bevorzugt eingesetzt werden Homopolyimide aus Struktureinheiten der Formel I.

Neben den diarylketonhaltigen Resten Q können copolymere Beschichtungsmaterialien noch weitere Reste Q' enthalten, die sich von unsubstituierten oder substituierten vierwertigen aromatischen Resten, an die je zwei Carbonylgruppen in ortho- oder peri-Position gebunden sind, ableiten.

Solche Reste besitzen in der Regel 6 bis 30, besonders 6 bis 20 C-Atome und gegenbenenfalls ein oder zwei Heteroatome, wie beispielsweise O, N oder S.

Bei allfälligen Substituenten des Restes Q' handelt es sich vorzugsweise um Alkylgruppen, besonders um Methyl. Bevorzugt werden unsubstituierte Reste Q'.

Bevorzugte Reste Q' sind in der EP—A 132,221 beschrieben. Zu den besonders bevorzugten Resten Q' dieses Typs zählen beispielsweise diejenigen der Formeln

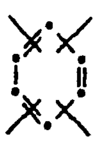 , 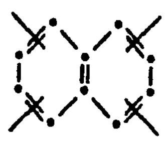 , 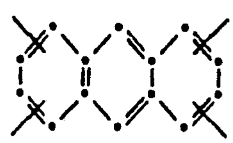 , 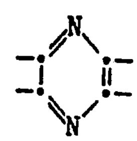 , 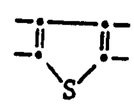 ,

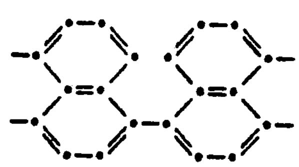 , 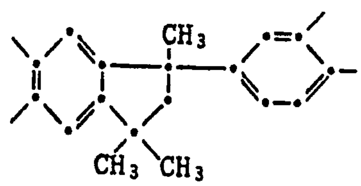 ,

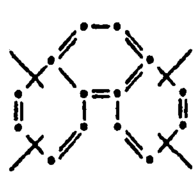 und 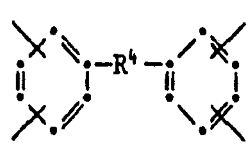 ,

worin $R^4$ eine direkte Bindung oder eine Brückengruppe der Formeln —O—, —S—, $—SO_2—$, $—CH_2—$ oder $—C(CH_3)_2—$ ist.

Die copolymeren Beschichtungsmaterialien können neben den Diaminodiphenylmethanresten der Formel II noch weitere Reste von Diaminen $R'^1$ enthalten, solange die Mindestmenge von Struktureinheiten der Formel I gegeben ist.

Solche Reste $R'^1$ leiten sich in allgemeinen von zweiwertigen unsubstituierten oder substituierten aliphatischen, gegebenenfalls durch Heteroatome, aromatische, heterocyclische oder cycloaliphatische Gruppen unterbrochenen aliphatischen Resten, von unsubstituierten oder substituierten cycloaliphatischen, aromatischen, heterocyclischen oder araliphatischen Gruppen ab.

Beispiele für solche Diaminreste findet man in der EP—A 134,752. Zu den besonders bevorzugten Cokomponenten $R'^1$ zählen aromatische Reste organischer Diamine, worin die aromatische Rest in beiden Orthostellungen zu mindestens einer Aminogruppe durch Alkyl, Cycloalkyl, Alkoxy, Alkoxyalkyl oder Aralkyl substituiert ist. Diamine dieses Typs sind in der EP—A 132,221 beschrieben. Besonders bevorzugt werden die Diaminreste III und IIIa der EP—A 132,221.

Besonders bevorzugt als Beschichtungsmaterialien werden (Co)polymide enthaltend 30—100 Mol-% der Strukturelemente der Formel I, worin $R^1$ eine Gruppe der Formel IIa bedeutet, $R^2$ und $R^3$ $C_1$—$C_6$Alkyl, insbesondere Methyl, sind und m und n unabhängig voneinander 0, 1 oder darstellen.

Weitere bevorzugt eingesetzte Copolyimide enthalten einen Mindestgehalt von 50 Mol-%, bezogen auf den Diaminanteil, an Resten der Formel IIa, worin $R^2$ und $R^3$ $C_1$—$C_6$Alkyl, insbesondere Methyl, sind, m und n unabhängig voneinander 0, 1 oder 2 darstellen und ergänzend dazu einen restlichen Diaminanteil mit aromatischen Reste $R'^1$ oder Gemischen solcher Reste, worin der aromatische Rest mindestens zwei Alkylsubstituenten in mindestens einer Orthostellung zu mindestens einer Aminogruppe aufweist, oder worin jeweils zwei dieser Alkylgruppen in ortho-Position zueinander stehen und zusammen eine Tetramethylenkette bilden.

Die erfindungsgemäss zu verwendenden Polymeren weisen mittlere Molekulargewichte (Zahlenmittel) von mindestens 2 000, vorzugsweise mindestens 5 000 auf. Die obere Grenze richtet sich im wesentlichen nach Eigenschaften, die die Verarbeitbarkeit bestimmen, wie. z.B. deren Löslichkeit. Sie kann bis zu 500 000, vorzugsweise bis zu 100 000 und besonders bis zu 60 000 betragen. Es kann sich ferner um statistische Polymere oder um Blockcopolymere handeln. Sie werden nach üblichen Verfahren in hierfür vorgesehenen Einrichtungen hergestellt. Die Polymeren sind vorzugsweise linear aufgebaut, können aber mit mindestens trifunktionellen Monomeren, die in kleinen Mengen zugesetzt werden, wenig verzweigt sein.

Im einzelnen geht man bei der Polyimidherstellung zweckmässig so vor, dass man das Tetracarbonsäuredianhydrid und das Diamin oder Gemische jeweils mehrer Anhydride und Diamine zunächst unter Bildung der Polyamidsäurevorstufe in an sich bekannter Weise umsetzt und diese Polyamidsäure anschliessend unter Wasserabspaltung cyclisiert. Die Cyclisierung kann thermisch erfolgen. Vorteilhaft wird die Cyclisierung unter Einwirkung von wasserentziehenden Mitteln, z.B. Carbonsäureanhydriden wie Acetanhydrid, vorgenommen. Die Polyimide können anschliessend nach üblichen Verfahren, z.B. durch Entfernen des Lösungsmittels oder Ausfällen durch Zugabe eines Nichtlösungsmittels, isoliert werden.

Eine weitere Herstellungsmethode besteht darin, dass man das Tetracarbonsäuredianhydrid mit einem Diisocyanat in einer Stufe zum Polyimid umsetzt.

Die zur Herstellung der erfindungsgemässen Beschichtungen einzusetzenden Polyimide oder Polyamidsäuren sind in unterschiedlichen Lösungsmitteln löslich, gegebenenfalls unter Erwärmen. Ueberraschenderweise sind die erfindungsgemäss verwendeten Polymeren bei gleichem Molekulargewicht lichtempfindlicher verglichen mit entsprechenden Polymeren enthaltend strukturisomere Diphenylmethaneinheiten. Sie eignen sich somit hervorrangend zur Herstellung von Filmen und Schutzüberzügen, insbesondere zur Herstellung von Isolier- und Schutzschichten für leitende, halbleitende oder isolierende Teil und zur Herstellung von wärmebeständigen Folien.

Beschichtungsmittel werden insbesondere in Form von Lösungen der erfindungsgemäss verwendeten Polymeren, bevorzugt der Polyimide, in einem Lösungsmittel eingesetzt.

Zur Herstellung des erfindungsgemäss beschichteten Materials löst man das Polymer oder Gemische davon zweckmässig in einem geeigneten organischen Lösungsmittel, gegebenenfalls unter Erwärmung.

Geeignete Lösungsmittel sind z.B. polare, aprotische Lösungsmittel, die allein oder in Mischungen aus mindestens zwei Lösungsmitteln verwendet werden können.

Beispiele sind: Ether, wie Dibutylether, Tetrahydrofuran, Dioxan, Methylenglykol, Dimethylethylenglykol, Dimethyldiethylenglykol, Diethyldiethylenglykol und Dimethyltriethylenglykol, halogenierte Kohlenwasserstoffe, wie Methylenchlorid, Chloroform, 1,2-Dichlorethan, 1,1,1-Trichlorethan und 1,1,2,2-Tetrachlorethan, Carbonsäureester und Lactone, wie Essigsäureethylester, Propionsäuremethylester, Benzosäureethylester, 2-Methoxyethylacetat, γ-Butyrolacton, o-Valerolacton und Pivalolacton, Carbonsäureamide und Lactone, wie Formamid, Acetamid, N-Methylformamid, N,N-Dimethylformamid, N,N-Diethylformamid, N,N-Dimethylacetamid, N,N-Diethylacetamid, γ-Butyrolactam, ε-Caprolactam, N-Methylpyrrolidon, N-Acetylpyrrolidon, N-Methylcaprolactam, Tetramethylharnstoff und Hexamethylphosphorsäureamid, Sulfoxide, wie Dimethylsulfoxid, Sulfone, wie Dimethylsulfon, Diethylsulfon, Trimethylensulfon und Tetramethylensulfon, tertiäre Amine, wie Trimethylamin, Triethylamin, N-Methylpyrrolidin, N-Methylpiperidin und N-Methylmorpholin, substituierte Benzole, wie Chlorbenzol, Nitrobenzol, Phenole oder Kresole.

Ungelöste Anteile können durch Filtration, bevorzugt einer Druckfiltration entfernet werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weiter übliche Zusatzstoffe einverleibt werden, die die Lichtempfindlichkeit nicht negativ beeinflussen. Beispiele herfür sind Mattierungsmittel, Verlaufmittel, feinteilige Füllstoffe, Flammschutzmittel, optische Aufheller, Antioxidantien, Stabilisatoren,

Lichtschutzmittel, Farbstoffe, Pigmente, Haftvermittler und Antihalofarbstoffe, wie sie z.B. in der US—PS 4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate oder Trägermaterialien, aufgebracht werden.

Geeignete Trägermaterialien oder Substrate sind z.B. Kunststoffe, beispeilsweise gehärtete Epoxidharze, Metalle und Metallegierungen, beispielsweise Eisen, Aluminium, Kupfer, Silber, Gold oder Bronze, Halbmetalle, beispielsweise Wismuth, Halbleiter, beispielsweise Germanium, Silizium, oder Galliumarsenid, Keramik oder andere anorganische Materialien, beispielsweise $SiO_2$ oder $Si_3N_4$.

Bevorzugte Trägermaterialien sind Metalle, Halbleiter oder Keramik, insbesondere Kupfer und Silizium. Die Trägermaterialien können ihrerseits als Laminate vorliegen, beispielsweise als kupferkaschierte Epoxidplatte. Ferner bevorzugt man als Träger anorganische Materialien, insbesondere $SiO_2$ und ganz besonders $Si_3N_4$.

Nach dem Beschichten wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis ca. 500 µm und mehr aufweisen.

Es wurde gefunden, dass die erfindungsgemäss verwendbaren Polymeren autophotovernetzbar sind und unter Strahlungseinwirkung vernetzt werden können, wenn sie mindestens 5 Mol-% Strukturelements der Formel I enthalten, worin Q ein Rest einer Arylketontetracarbonsäure ist. Da die Lichtempfindlichkeit mit steigendem Gehalt an solchen Strukturelementen steigt, ist ein Gehalt von mindestens 30 Mol-% bevorzugt mindestens 50 Mol-% und besonders mindestens 80 Mol-% vorteilhaft.

Schutzfilme aus diesen Polyimiden können durch Strahlungseinwirkung weiter modifiziert werden, womit z.B. noch weitere erhöhte Thermostabilitäten möglich sind. Ferner besteht die Möglichkeit, solche Polyimide als photographisches Aufzeichnungsmaterial für Reliefabbildungen einzusetzen. Die Polymerschicht der erfindungsgemäss beschichteten Materials weist eine für viele Anwendungsfälle ausreichende und teilweise hohe Lichtempfindlichkeit auf und sie kann direkt photovernetzt werden. Durch die Direktvernetzung unter Strahlungseinwirkung können Zusätze wie Sensibilisatoren vermieden werden und die Schutzschichten, Abbildungen und Filme weisen ausgezeichnete elektrische Eigenschaften auf. Ferner zeichnen sie sich durch hohe Haftfestigkeit und thermische, mechanische und chemische Widerstandsfähigkeit aus. Bei thermischen Nachbehandlungen wird nur ein geringer Schwund beobachtet, was in der Anwendung erhebliche Vorteile hat, weil praktisch keine Verzerrung abgebildeter Strukturen beobachtet wird bzw. weil keine inneren Spannungen in Ueberzügen und Filmen entstehen.

Des Material ist lagerstabil, aber vorteilhaft vor Lichteinwirkung zu schützen.

Die Herstellung von Schutzfilmen erfolgt in der Regel durch direktes Belichten, wobei sich die Belichtungszeiten im wesentlichen nach den Schichtdicken und der Lichtempfindlichkeit richten und von Fachmann mittels üblicher Verfahren bestimmt werden können.

Die photographische Erzeugung der Reliefstruktur erfolgt in der Regel durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Zum Gegenstand der Erfindung zählt auch ein Verfahren zur Herstellung von Schutzüberzügen oder von Filmen umfassend die Schritte

i) Beschichten eines Trägermaterials mit einer zumindest teilweise cyclisierten Polyamidsäure- oder Polyimidschicht, wie oben definiert,

ii) Bestrahlen des beschichteten Materials mit aktinischer Strahlung, so dass die Polymerschicht in ihrer gesamten Fläche vernetzt wird,

ii) gegebenenfalls thermische Nachbehandlung und

iv) gegebenenfalls Ablösen des vernetzten Films von besagtem Trägermaterial.

Ferner betrifft die Erfindung ein Verfahren zur Herstellung von Reliefabbildungen umfassend die Schritte

i) Beschichten eines Trägermaterials mit einer zumindest teilweise cyclisierten Polyamidsäure- oder Polyimidschicht, wie oben definiert,

ii) Bestrahlen des beschichten Materials mit einem Muster aktinischer Strahlung, so dass die bestrahlten Stellen besagter Polymerschicht vernetzt werden und

iii) Entwickeln des Systems mit einem geeigneten Entwickler.

Sowohl zur Herstellung von Schutzüberzügen als auch zur Herstellung von Reliefabbildungen gemäss den oben definierten Verfahren lassen sich auch zumindest teilweise cyclisierte Polyamidsäure- oder Polyimidschichten auf Glasträgern einsetzten.

Zum Gegenstand der Erfindung zählen ferner die durch Strahlungsvernetzung erhaltenen Schutzüberzüge, Filme und Reliefabbildungen.

Die Photostrukturierung bzw. Photovernetzung kann durch aktinische Strahlung hervorgerufen werden, z.B. durch UV-Licht, Röntgenstrahlen, Laserlicht oder Elektronenstrahlen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten und intergrierter Schaltkreise, Relais für die Herstellung von

Röntgenmasken, als Lötstopplack, als Dielektrikum für Mehrlagenschaltungen, als Strukturelement für Flüssigkristallanzeiger.

Zum Gegenstand dieser Erfindung zählt auch die Verwendung des oben definierten beschichteten Materials zur Herstellung von Isolier-, Passivier- und Schutzschichten und von Reliefabbildungen. Die Schichtdicke der Polymerschicht beträgt für diese Anwendungen bevorzugt 0,5 bis 100 µm, besonders 1 bis 50 µm und insbesondere 1 bis 10 µm.

Die nachfolgenden Beispiele erläutern die Erfindung näher.

## Herstellungsbeispiele

Beispiel A: Herstellung von 2,2'-Diaminodiphenylmethan

Die Herstellung erfolgt nach M. W. Partridge und H. J. Vipond, J. Chem. Soc., *1962*, 632.

Beispiel B: Herstellung von 2,2'-Diamino-3,3',5,5'-tetramethyldiphenylmethan

Die Herstellung erfolgt in Analogie zum Beispiel A gemäss folgendem Schema:

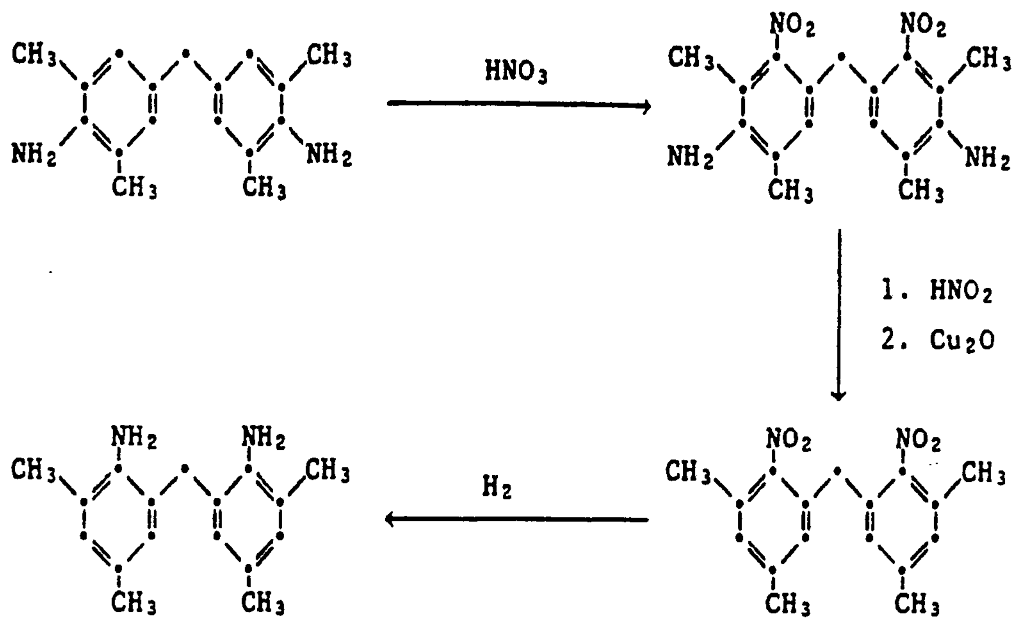


**Elementaranalyse**

| | C | H | N |
|---|---|---|---|
| Berechnet | 80,27 | 8,72 | 11,01 |
| Gefunden | 80,22 | 8,99 | 10,87 |

FP. 124-25 °C.

## Herstellung der Polyimide

Beispiel 1

In einem zylindrischem Rührgefäss mit Rührer, Tropftrichter, Innenthermometer, Gaseinleitungs- und Gasableitungsrohr werden 2,54 g (0,01 Mol) 2,2'-Diamino-3,3',5,5'-tetramethyldiphenylmethan in 23 ml NMP gelöst und unter gleichzeitigem Einleiten von $N_2$ auf ca. 0°C abgekühlt. Zu dieser Lösung werden 3,22 g (0,01 Mol) 3,3',4,4,'-Benzophenontetracarbonsäuredianhydrid (BTDA) gegeben und die Kühlung entfernt.

Nach 5 Stunden wird eine Lösung von 2,22 g Triethylamin und 9,18 g Acetanhydrid eingetropft und die Mischung 18 Stunden bei Raumtemperatur gerührt.

Die Polymerlösung wird auf Wasser gegossen, das Polymer abfiltriert, mit viel Wasser gewaschen und getrocknet.

Die inhärente Viskosität, gemessen also 0,5 prozentige Lösung in NMP bei 25°C, beträgt 0,19 dl/g.

Die Glasumwandlungstemperatur (DSC) beträgt 273°C.

Beispiele 2 und 3

Analog Beispiel 1 werden folgende Diamingemische mit einer stöchiometrischen Menge BTDA umgesetzt und mit Triethylamin und Acetanhydrid zum Polyimid cyclisiert:

| Beispiel | Diamine | η inh.(dl/g) | Tg(°C) (DSC) |
|---|---|---|---|
| 2 | Diamin aus Beispiel B (50 Mol-%)<br>2,4-Diaminotoluol (50 Mol-%) | 0,36 | 277 |
| 3 | 2,2'-Diaminodiphenyl-methan (50 Mol-%)<br>2,4-Diaminotoluol (50 Mol-%) | 0,26 | 314 |

Anwendungsbeispiele

Auf einer einseitig kupferkaschierten Kunststoffplatte wird ein dünner (ca. 1—2 µm) Polymerfilm erzeugt, indem eine 5 %ige Polymerlösung aufgeschleudert wird und das Lösungsmittel anschliessend in einem Umluftofen entfernt wird. Als Lösungsmittel wird N-Methylpyrrolidon verwendet.

Die so beschichten Platten werden durch eine Photomaske (Stouffer-Keil) bei Raumtemperatur mit einer 100 Watt-UV-Lampe aus 18 cm Entfernung belichtet. Die belichteten Platten werden anschliessend mit einem Lösungsmittel entwickelt wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung.

| Polymer gemäss Beispiel | Belichtungszeit (sec) | Empfindlichkeit (Stouffer Skala) |
|---|---|---|
| 1 | 180 | 7 |
| 2 | 180 | 5 |
| 3 | 210 | 6 |

**Patentansprüche**

1. Beschichtetes Material aus mindestens einem Träger und einer darüberliegenden strahlungsempfindlichen zumindest teilweise cyclisierten Polyamidsäure- oder Polyimidschicht, dadurch gekennzeichnet, dass das Polymere mindestens 5 Mol-%, bezogen auf das Gesamtpolymere, an Struktureinheiten der Formel I enthält

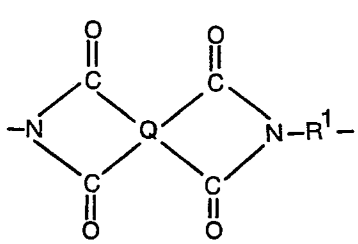

(I),

worin der Rest Q ausgewählt ist aus der Gruppe bestehend aus

a) Derivaten der Benzophenontetracarbonsäure

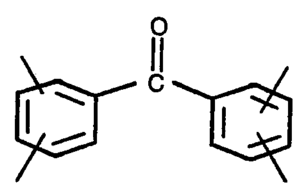

und

b) Strukturen der Formel III

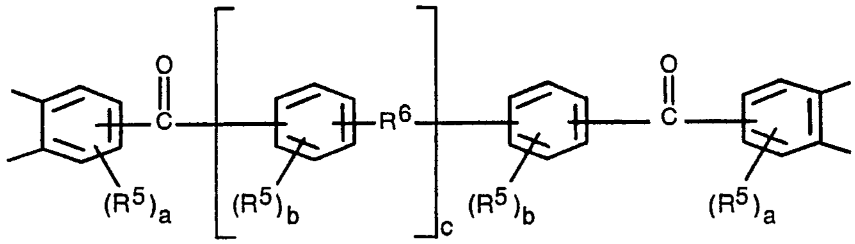

(III),

worin $R^5$ für $C_1$—$C_6$Alkyl, $C_1$—$C_6$Alkoxy, $C_1$—$C_6$Alkylthio, Phenyl, Phenyloxy oder Phenylthio steht, $R^6$ eine direkte Bindung oder eine Brückengruppe der Formeln —O—, —S—, —$SO_2$—, —$CH_2$—, —$C(CH_3)_2$— oder —CO— bedeutet a für 0, 1, 2 oder 3, b für 0, 1, 2, 3 oder 4 und c für 0, 1, 2, 3, 4 oder 5 steht, und, wenn a und b 2 sind, beide $R^5$ zusätzlich zu den obigen Definitionen in o-Stellung gebunden sind und zusammen —CH=CH—CH=CH— bedeuten, und $R^1$ ein Rest der Formel II ist

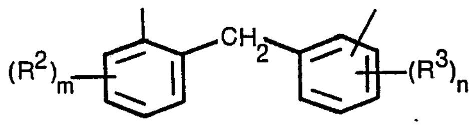

(II),

worin $R^2$ und $R^3$ unabhängig voneinander Alkyl, Cycloalkyl oder Aralkyl bedeuten oder jeweils zwei Reste $R^2$ oder $R_3$ in ortho-Position zueinander stehen und zusammen eine Tetramethylenkette bilden und m und n unabhängig voneinander ganze Zahlen von 0 bis 4 sind, jedoch nicht gleichzeigig 0 werden können wobei Glas als Tragermaterial ausgeschlossen ist.

2. Beschichtetes Material gemäss Anspruch 1, worin Q ausgewählt ist aus der der Gruppe bestehend aus Resten der Formeln IIIa und IIIb

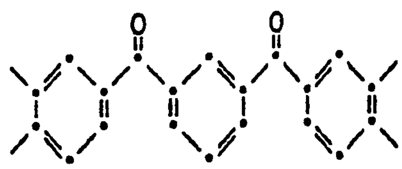

(IIIa),

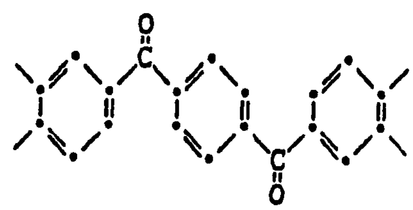

(IIIb).

3. Beschichtetes Material gemäss Anspruch 1, worin $R^1$ eine Gruppe der Formel IIa ist

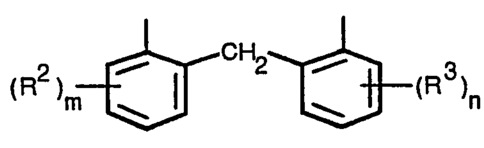

(IIa),

4. Beschichtetes Material gemäss Anspruch 3, worin $R^1$ ein Rest der Formel IIb ist

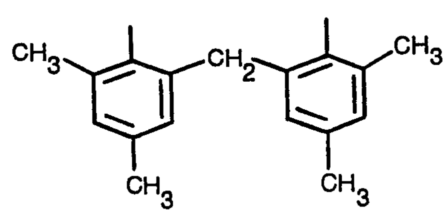

(IIb).

5. Beschichtetes Material gemäss Anspruch 1, worin Homopolyimide aus Struktureinheiten der Formel I eingesetzt werden.

6. Beschichtetes Material gemäss Anspruch 1, worin (Co)polyimide enthaltend 30—100 Mol-% der Strukturelemente der Formel I verwendet werden, worin $R^1$ eine Gruppe der Formel IIa gemäss Anspruch 4 bedeutet, $R^2$ und $R^3$ $C_1$—$C_6$Alkyl sind und m und n unabhängig voneinander 0, 1 oder 2 darstellen.

7. Beschichtetes Material gemäss Anspruch 1, worin ein Copolyimid eingesetzt wird enthaltend einen Mindestanteil von 50 Mol-%, bezogen auf den Diaminanteil, an Resten der Formel IIa gemäss Anspruch 4, worin $R^2$ und $R^3$ $C_1$—$C_6$Alkyl sind und m und n unabhängig voneinander 0, 1 oder 2 darstellen und ergänzend dazu einen restlichen Diaminanteil mit aromatischen Resten $R'^1$ oder Gemischen solcher Reste, worin der aromatische Rest mindestens zwei Alkylsubstituenten in mindestens einer Orthostellung zu mindestens einer Aminogruppe aufweist, oder worin jeweils zwei dieser Alkylgruppen in ortho-Position zueinander stehen und zusammen eine Tetramethylenkette bilden.

8. Verfahren zur Herstellung von Schutzüberzügen oder von Filmen umfassend die Schritte

i) Beschichten eines Trägermaterials mit einer zumindest teilweise cyclisierten Polyamidsäure- oder Polyimidschicht gemäss Anspruch 1,

ii) Bestrahlen des beschichteten Materials mit aktinischer Strahlung, so dass die Polymerschicht in ihrer gesamten Fläche vernetzt wird,

iii) gegebenenfalls thermische Nachbehandlung und

iv) gegebenenfalls Ablösen des vernetzten Films von besagtem Trägermaterial.

9. Verfahren zur Herstellung von Reliefabbildungen umfassend die Schritte

i) Beschichten eines Trägermaterials mit einer zumindest teilweise cyclisierten Polyamidsäure- oder Polyimidschicht gemäss Anspruch 1,

ii) Bestrahlen des beschichteten Materials mit einem Muster aktinischer Strahlung, so dass die bestrahlten Stellen besagter Polymerschicht vernetzt werden und

iii) Entwickeln des Systems mit einem geeigneten Entwickler.

10. Verwendung des beschichteten Materials gemäss Anspruch 1 zur Herstellung von Isolier-, Passivier- und Schutzschichten und von Reliefabbilddungen.

**Revendications**

1. Matériau enduit formé d'un support qui porte une couche d'un polyamide-acide ou d'un polyimide au moins partiellement cyclisé et photosensible, caractérisé en ce que le polymère comprend au moins 5 mol-% de son ensemble de motifs de formule I ci-dessous:

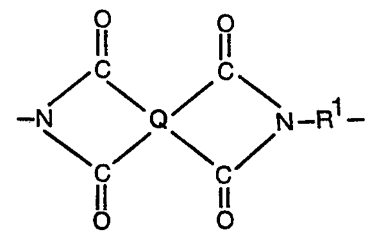

(I),

dans laquelle le radical Q est choisi parmi:

a) des dérivés d'acide benzophénone-tétracarboxylique:

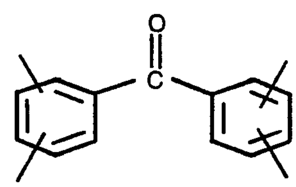

b) des radicaux de formule III:

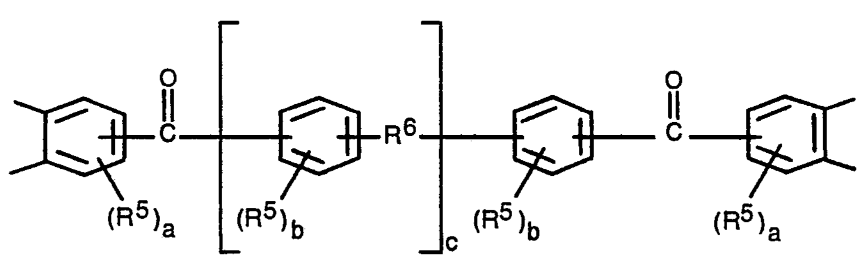

(III),

$R^5$ désignant un alkyle, un alcoxy ou un alkylthio en $C_1$—$C_6$, ou bien un groupe phényle, phényloxy ou phénylthio,

$R^6$ une liaison directe ou bien un atome ou un groupe formant pont, —O—, —S—, —$SO_2$—, —$CH_2$—, —$C(CH_3)_2$— ou —CO—,
a = 0, 1, 2 ou 3,
b = 1, 2, 3 ou 4 et
c = 0, 1, 2, 3, 4 ou 5 et, si
a et b sont chacun le nombre 2, dans les deux cas, deux radicaux ensemble le groupe —CH=CH—CH=CH—, et
$R^1$ représente un radical de formule II:

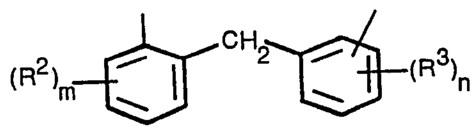

(II),

$R^2$ et $R^3$ désignant chacun, indépendamment l'un de l'autre, un alkyle, un cycloalkyle ou un aralkyle ou bien deux radicaux $R^2$ ou deux radicaux $R^3$ sont en position ortho l'un par rapport à l'autre et forment ensemble un groupe tétraméthylène, et n et m étant chacun, indépendamment l'un de l'autre, un entier de 0 à 4, mais ne pouvant être nuls tous les deux à la fois, le verre étant exclu comme support pour ce matériau.

2. Matériau selon la revendication 1, caractérisé en ce que le radical Q est choisi parmi les radicaux de formules IIIa et IIIb:

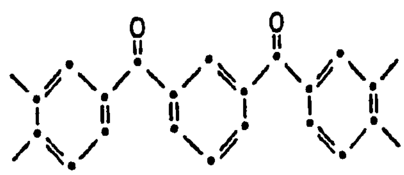

(IIIa),

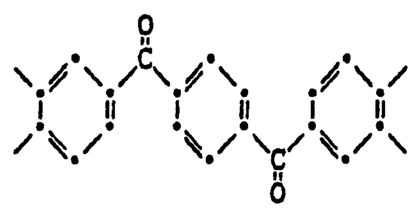

(IIIb).

3. Matériau selon la revendication 1, caractérisé en ce que $R^1$ est un groupe de formule IIa:

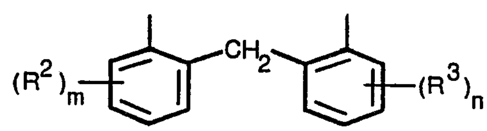

(IIa),

4. Matériau selon la revendication 3, caractérisé en ce que $R^1$ est un groupe de formule IIb:

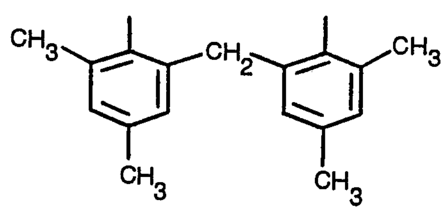

(IIb).

5. Matériau selon la revendication 1 qui comprend des homopolyimides de motifs de formule I.

6. Matériau selon la revendication 1 qui comprend des polyimides ou des copolyimides avec de 30 à 100 mol-% de motifs de formule I dans lesquels $R^1$ est un groupe de formule IIa de la revendication 3, $R^2$ et $R^3$ étant des alkyles en $C_1$—$C_6$ et m et n étant chacun le nombre 0, 1 ou 2.

7. Matériau enduit selon la revendication 1 qui comprend un copolyimide ayant une teneur minimale de 50 mol-%, par rapport à la proportion des diamines, en radicaux de formule IIa de la revendication 3 dont $R^2$ et $R^3$ sont des alkyles en $C_1$—$C_6$ et m et n sont chacun le nombre 0, 1 ou 2, avec comme complément des radicaux aromatiques $R'^1$ de diamines, identiques ou différents, avec au moins substituants alkyliques en au moins une position ortho par rapport à au moins un groupe amino, ou bien dans chaque cas deux de ces substituants alkyliques sont en position ortho l'un par rapport à l'autre et forment ensemble un groupe tétraméthylène.

8. Procédé de formation de revêtements protecteurs ou de pellicules, qui comprend les opérations suivantes:

1) revêtement d'un support d'une couche d'un polyamide-acide ou d'un polyimide au moins partiellemnt cyclisé, selon la revendication 1,

2) irradiation du matériau recouvert par un rayonnement actinique de manière que la couche du polymère se réticule sur toute sa surface,

3) éventuellement traitement à la chaleur, et

4) éventuellement séparation de la pellicule reticulée de son support.

9. Procédé de formation d'images et représentations en relief, qui comprend les opérations suivantes:

1) revêtement d'un support d'une couche d'un polyamide-acide ou d'un polyimide au moins partiellement cyclisé selon la revendication 1,

2) irradiation du matériau recouvert par un rayonnement actinique suivant un modèle de dessin donné de manière que les parties irradiées de la couche du polymère se réticulent, et

3) développement avec un révélateur approprié.

10. Utilisation du matériau enduit selon la revendication 1 pour former des couches isolantes, passivantes et protectrices et des images en relief.

**Claims**

1. A coated material comprising at least one base material and, superimposed thereon, a radiation-sensitive at least partially cyclized polyamide acid of polyimide layer, wherein the polymer contains at least 5 mol-%, based on the total polymer, of structural units of the formula I

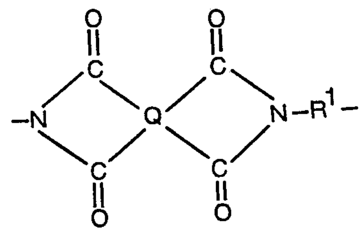

(I),

in which the radical Q is selected from the group consisting of

a) derivatives of benzophenonetetracarboxylic acid

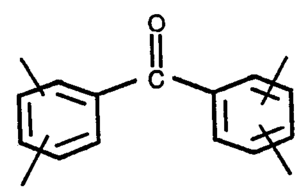

b) structures of the formula III

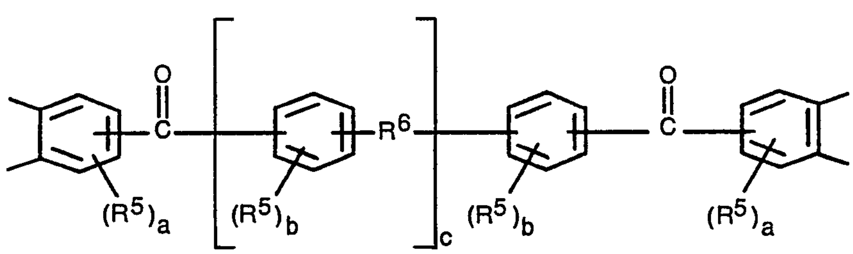

(III),

in which $R^5$ is $C_1$—$C_6$alkyl, $C_1$—$C_6$alkoxy, $C_1$—$C_6$alkylthio, phenyl, phenyloxy or phenylthio, $R^6$ is a direct bond or a bridge group of the formulae —O—, —S—, —$SO_2$—, —$CH_2$—, $C(CH_3)_2$— or —CO—, a is 0, 1, 2 or 3, b is 0, 1, 2, 3 or 4, and c is 0, 1, 2, 3, 4 or 5, and, where a and b are 2, the two $R^5$s are in addition to the above definitions bonded in the o-position and together are —CH=CH—CH=CH—, and $R^1$ is a radical of the formula II

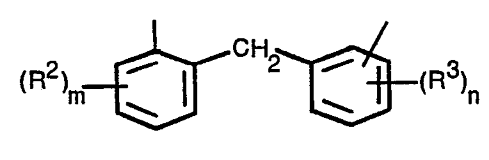

(II),

in which $R^2$ and $R^3$ are each independently of the other alkyl, cycloalkl or aralkyl or pairs of radicals $R^2$ and $R^3$ are bonded in the ortho-position relative to each other and together form a tetramethylene chain, and m and n are each independently of the other integers from 0 to 4, but cannot simultaneously be 0, glass being ruled out from use as base material.

2. A coated material according to claim 1, in which Q is selected from the groupe consisting of radicals of the formulae IIIa and IIIb

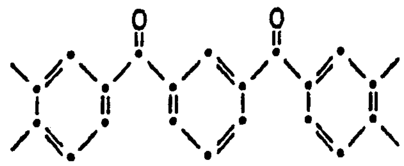

(IIIa),

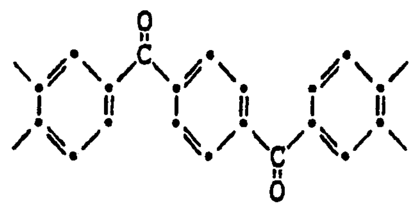

(IIIb).

3. A coated material according to claim 1, wherein $R^1$ is a group of the formula IIa

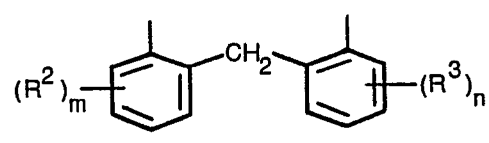

(IIa),

4. A coated material according to claim 3, wherein $R^1$ is a radical of the formula IIb

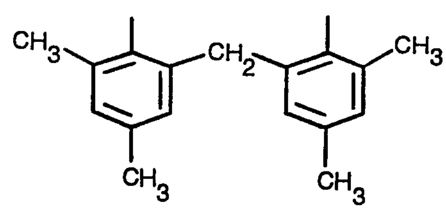

(IIb).

5. A coated material according to claim 1, wherein homopolyimides composed of structural units of the formula I are used.

6. A coated material according to claim 1, wherein (co)polyimides are used containing 30—100 mol-% of structural elements of the formula I in which $R^1$ is a group of the formula IIa according to claim 4, $R^2$ and $R^3$ are $C_1$—$C_6$-alkyl and m and n are independently of each other 0, 1 or 2.

7. A coated material according to claim 1, wherein a copolyimide is used containing a minimum proportion of 50 mol-%, based on a diamine content, of radicals of the formula IIa according to claim 4 in which $R^2$ and $R^3$ are $C_1$—$C_6$-alkyl and m and n are independently of each other 0, 1 or 2, and, complimentarily thereto, a residual diamine content having aromatic radicals $R'^1$ or mixtures of such radicals in which the aromatic radical has at least two alkyl substituents in at least one ortho-position relative to at least one amino group, or in which in each case two of these alkyl groups are in the ortho-position relative to each other and together form a tetramethylene chain.

8. A process for the preparation of protective coatings or of films comprising the steps

i) coating a base material with an at least partially cyclized polyamide acid or polyimide layer according to claim 1,

ii) irradiating the coated material with actinic radiation so that the polymer layer is crosslinked over its entire area,

iii) if desired a thermal aftertreatment and

iv) if desired detaching the crosslinked film from said base material.

9. A process for the preparation of relief images comprising the steps

i) coating a base material with an at least partially cyclized polyamide acid or polyimide layer according to claim 1,

ii) irradiating the coated material with a pattern of actinic radiation so that the irradiated areas of said polymer layer are crosslinked and

iii) developing the system with a suitable developer.

10. Use of the coated material according to claim 1 for preparing insulating, passivating and protective layers and relief images.